# DEMANDE DE BREVET EUROPEEN

(11) **EP 4 719 019 A1**
(43) Date de publication de la demande: **01.04.2026**
(21) Numéro de dépôt: 25203320.4
(22) Date de dépôt: 19.09.2025
(51) Int. Cl.: H10K 85/50, H10F 77/12, H10K 30/40, H10K 30/57

(54) **COMPOSITIONS OPTIMALES DE PÉROVSKITES INORGANIQUES POUR LA FABRICATION DE DISPOSITIFS ÉLECTRONIQUES, NOTAMMENT PHOTOVOLTAÏQUES**

(30) Priorité: 20.09.2024 FR 2410076
(71) Demandeur: Institut Photovoltaique D'Ile de France (IPVF), 91120 Palaiseau (FR); Electricité de France, 75008 Paris (FR); TotalEnergies OneTech, 92400 Courbevoie (FR); Ecole Polytechnique, 91120 Palaiseau (FR); Centre National de la Recherche Scientifique, 75016 Paris (FR)
(72) Inventeur: Baranek, Philippe, 91530 SAINT MAURICE MONTCOURONNE (FR); Antoine, Gissler, 75014 PARIS (FR); Schulz, Philip, 94260 FRESNES (FR)
(74) Mandataire: Plasseraud IP

(57) **Abrégé**

Il est proposé un dispositif électronique comportant au moins une couche réalisée dans un matériau comportant une pérovskite inorganique :
* de composition stœchiométrique ABX₃ où :
- A est un élément parmi Cs et Rb,
- B est un élément ou un mélange d'éléments parmi Ge, Sn et Pb, et
- X est un élément ou un mélange d'éléments parmi Cl, Br et I,

* et ayant un facteur de Goldschmidt t compris entre 0,87 et 0,93, caractérisant une stabilité satisfaisante.

## Description

La présente divulgation concerne le domaine de la fabrication de dispositifs électroniques, notamment photovoltaïques, par exemple de type panneaux solaires pour une exploitation d'énergies renouvelables.

Elle porte plus particulièrement sur la fabrication de compositions chimiques de pérovskites inorganiques potentiellement stables (notamment en température) et leur utilisation notamment dans le domaine précité. En effet, en fonction de leurs bandes d'énergie interdite, ces matériaux peuvent être utilisés aussi bien comme absorbeurs, couches de passivations, ou autres, notamment pour différentes technologies de cellules photovoltaïques (en tandem, ou multi-jonctions, ou autres).

Les pérovskites halogénées sont facilement synthétisables (par voie liquide par exemple) et d'une mise en œuvre "aisée" (en couches minces notamment). Leur largeur de bande interdite (ou « gap » ci-après) permet une plus large absorption du spectre solaire en comparaison avec des matériaux conventionnels (filière silicium, filière CuInGa(SSe)₂ ou « CIGS » ci-après, etc.). Ils atteignent actuellement des rendements de 26% et sont à la base de cellules tandem avec des rendements supérieurs de 33%.

Néanmoins, ces pérovskites restent instables et ne permettent pas d'envisager actuellement un déploiement commercial de cette technologie. Différents facteurs de vieillissement sont notamment le rayonnement ultraviolet reçu (« UV » ci-après), la présence d'eau (H₂O) ou d'oxygène (O₂), la température et bien entendu le type de techniques mises en œuvre pour leur fabrication.

L'une des raisons de leur instabilité est liée à l'entité organique des pérovskites. De nombreuses solutions ont été explorées (effets des substitutions, des techniques d'encapsulation des pérovskites, etc.), mais il reste à trouver une technique facilement exploitable pour obtenir une stabilité de longue durée au-delà de quelques milliers d'heures aujourd'hui et vers une durée de vie de matériau d'un dispositif photovoltaïque, habituellement de quelques dizaines d'années.

Une technique semble émerger récemment. Elle repose sur l'utilisation de pérovskites inorganiques, de la famille des « ABX₃ » (où A = K, Rb et Cs; B = Ge, Sn et Pb ; et X = Cl, Br et I) par exemple. Elles ont des rendements proches de 21%, possèdent une bonne stabilité dans des conditions normales d'utilisation et l'impact de molécules comme l'eau sur leurs propriétés électroniques semble moins important que pour les pérovskites organiques. Elles sont ainsi aussi de bonnes candidates pour des couches de passivation.

La détermination de compositions chimiques adéquates pour des pérovskites halogénées inorganiques devrait procurer des performances potentielles de stabilité en température, et de tolérance à différents contaminants contenus dans l'air ambiant, comme l'eau. Des caractéristiques optoélectroniques, satisfaisant les contraintes de cellules photovoltaïques fabriquées à l'échelle industrielle et à usage classique de plein air, devraient alors pouvoir être obtenues.

Un facteur d'instabilité de ces matériaux toutefois est leurs riches séquences de transitions de phase en température et/ou en pression.

La présente invention vient améliorer la situation.

Elle part de l'observation que ces instabilités dans ce type de matériaux sont souvent liées à l'existence de modes de vibrations ou phonons, dits « modes mous » ou « modes instables ».

Elle part aussi de l'observation que ces instabilités sont minimales pour des gammes de composition de pérovskites inorganiques qui ont des gaps compatibles avec des applications photovoltaïques, aussi bien pour des cellules simple jonction que des cellules tandem ou multi-jonctions avec du silicium ou du CIGS. Avec du silicium notamment, la composition de la pérovskite retenue peut être choisie pour assurer un accord de maille.

Par ailleurs, il a été observé que certaines de ces pérovskites inorganiques ainsi obtenues avaient des constantes diélectriques statiques très élevées, formant alors des candidats de choix pour l'élaboration de matériaux à effets super-capacitifs, notamment pour des dispositifs électroniques de type supercondensateurs.

Ainsi, plus généralement, il a été observé que les modes de vibration, instables, précités, étaient bien moindres dans certaines familles particulières de compositions et que leur fabrication en couche mince dans tous types de dispositif électronique ne présentait donc pas de difficultés particulières par rapport à celle d'autres pérovskites.

Ainsi, il est visé ici un dispositif électronique comportant au moins une couche réalisée dans un matériau comportant une pérovskite inorganique :
* de composition stœchiométrique ABX₃ où :
   - A est un élément parmi Cs et Rb,
   - B est un élément ou un mélange d'éléments parmi Ge, Sn et Pb, et
   - X est un élément ou un mélange d'éléments parmi Cl, Br et I,
* et ayant un facteur de Goldschmidt t compris entre 0,87 et 0,93.

Il a été mené une approche de calcul de modes de phonons et d'étude de la stabilité d'amplitude des modes de vibration correspondants. Une amplitude de vibration dite « instable » peut s'expliquer par une fréquence de phonons qui a été calculée comme étant négative.

Il a été alors observé en effet :
- d'une part, une corrélation vérifiée entre le facteur de tolérance dit « de Goldschmidt *t »* (idéalement voisin ou égal à 0,9) et la stabilité de la pérovskite inorganique, et
- d'autre part, qu'il était possible, par cette approche de calcul de modes de phonons, de déterminer finement au moins le type de cations A qui pouvait offrir une stabilité de pérovskite prometteuse (donc parmi Cs (césium) et Rb (rubidium), selon cette détermination).

Dans un mode de réalisation, le matériau considéré est au moins partiellement cristallin, selon une structure cristallographique de type *Pm*3̅*m.*

Les calculs de modes de phonons précités ont pu être réalisés en effet en considérant par exemple une supercellule de dimensions multiples d'une maille élémentaire ayant cette symétrie *Pm*3̅*m.*

Le calcul de modes de phonons précité a permis non seulement de déterminer les types de cations A offrant la meilleure stabilité, mais aussi le type de mélange de cations B et/ou d'anions X offrant une stabilité optimale.

Ainsi, dans une réalisation, la pérovskite inorganique est alors plus particulièrement de composition stœchiométrique A(B_{z}B'_{1-z})(X_{y}X'_{1-y})₃ où :
- z et y sont compris entre 0 et 1 (supérieurs ou égaux à 0 et inférieurs ou égaux à 1),
- A est un élément parmi Cs et Rb,
- B et B' sont des éléments distincts parmi Ge, Sn et Pb, et
- X et X' sont des éléments distincts parmi Cl, Br et I.

Lorsque le cation A est du césium (Cs), il a été observé que le matériau est dépourvu de mode de vibration instable lorsqu'il est choisi parmi les compositions : CsGe_{0.25}Pb_{0.75}(Br_{0.5}Cl_{0.5})₃, CsPb_{0.125}Sn_{0.875}I₃, CsPb_{0.25}Sn_{0.75}I₃, CSPb_{0.375}Sn_{0.625}(Br_{0.25}Cl_{0.75})₃, CSPb_{0.5}Sn_{0.5}(Br_{0.25}Cl_{0.75})₃, CsPb_{0.5}Sn_{0.5}Br₃, CsPb_{0.5}Sn_{0.5}Cl₃, CsPb_{0.625}SN_{0.375}Cl₃, et CsPb_{0.75}Sn_{0.25}Cl₃.

Ainsi, dans une réalisation du dispositif électronique, le matériau est dépourvu de mode de vibration instable et est choisi parmi l'une des neuf compositions ci-avant.

Dès lors qu'une pluralité de compositions offre une bonne stabilité de pérovskite, il est possible de sélectionner en particulier au moins une composition pour une application visée. Par exemple dans une réalisation où le dispositif électronique est en particulier de type photovoltaïque et où la couche précitée est à propriétés photovoltaïques, le matériau peut être choisi, à la fois, pour :
- être dépourvu de mode de vibration instable, et
- avoir une largeur de bande interdite (ou « gap » ci-après) comprise entre 1,4eV et 2,3eV, compatible avec une application photovoltaïque.

Dans ce cas, le matériau peut être sélectionné parmi les trois compositions CsPb_{0.375}Sn_{0.625}(Br_{0.25}Cl_{0.75})₃, CSPb_{0.5}Sn_{0.5}(Br_{0.25}Cl_{0.75})₃, et CsPb_{0.5}Sn_{0.5}Br₃.

En effet, il a été observé que ces trois compositions avaient des gaps compris entre 1,4eV et 2,3eV et étaient dépourvues de mode de vibration instable.

Dans un exemple de réalisation où le dispositif est de type photovoltaïque et à cellule tandem ou multi-jonctions comportant une couche de silicium, et où la couche précitée est à propriétés photovoltaïques avec une largeur de bande interdite comprise entre 1,4eV et 2,3eV, la pérovskite inorganique peut alors avoir une composition de type Rb(PbₓSn₁₋ₓ)Br₃, avec x compris entre 0 et 0,7, avec une taille de maille proche d'une taille de maille du silicium pour déposer les couches de silicium et de pérovskite l'une sur l'autre.

En effet, cette autre famille de compositions à base de rubidium, Rb(PbₓSn₁₋ₓ)Br₃, avec x compris entre 0 et 0,7, présente aussi (outre celles à base de césium) l'avantage d'avoir :
- Un nombre de modes instables limité (inférieur à 10, alors que d'autres compositions à base du rubidium peuvent avoir plus de 30 modes instables), et
- Des gaps compris entre 1,4 et 2,3 eV.

En outre, pour cette famille à base de rubidium, la taille de maille est suffisamment proche de celle du silicium cristallin de sorte qu'un taux de dislocations relativement faible ou tout au moins maitrisé peut être obtenu dans l'empilement pérovskite/silicium.

Toujours dans une réalisation où le dispositif est de type photovoltaïque, mais où la couche est une couche de passivation (donc de gap supérieur à 2,3eV), le matériau est dépourvu de mode de vibration instable s'il est choisi parmi les compositions CsGe_{0.25}Pb_{0.75}(Br_{0.5}Cl_{0.5})₃, CsPb_{0.5}Sn_{0.5}Cl₃, CsPb_{0.625}SN_{0.375}Cl₃ et CsPb_{0.75}Sn_{0.25}Cl₃.

Dans une réalisation où le dispositif est de type supercondensateur, le matériau peut être choisi pour des effets super-capacitifs et il est dépourvu de mode de vibration instable s'il est choisi parmi les compositions : CsGe_{0.25}Pb_{0.75}(Br_{0.5}Cl_{0.5})₃, CsPb_{0.125}Sn_{0.875}I₃, CsPb_{0.25}Sn_{0.75}I₃, et CsPb_{0.5}Sn_{0.5}(Br_{0.25}Cl_{0.75})₃.

En effet, il a été calculé en outre la constante diélectrique statique des pérovskites stables à base de césium et des résultats très prometteurs (avec des constantes diélectriques statiques supérieures à 100) ont été relevés pour les quatre compositions ci-dessus.

Selon un autre aspect, il est visé un procédé mis en œuvre par des moyens informatiques pour estimer une stabilité de pérovskite inorganique de composition stœchiométrique ABX₃ où :
- A est au moins un élément parmi Li, Na, K, Rb et Cs,
- B est au moins un élément ou un mélange d'éléments parmi Ge, Sn et Pb, et
- X est au moins un élément ou un mélange d'éléments parmi Cl, Br et I,

Le procédé comportant :
- Considérer une supercellule ayant des dimensions multiples (par exemple 2x2x2) de la taille d'une maille élémentaire d'un cristal de ladite pérovskite inorganique,
- Pour chaque élément A et pour différents mélanges de cations B et différents mélanges d'anions X, tester des modes de phonons caractérisant des vibrations dans la supercellule pour identifier des modes de vibration à amplitude instable (typiquement ayant des fréquences de phonons négatives), et déterminer pour chaque composition un nombre de modes à amplitude instable,
- Sélectionner au moins une composition dont le nombre de modes de vibration à amplitude instable est inférieur à un seuil,
   En vue d'utiliser la composition sélectionnée pour la fabrication d'un dispositif électronique comportant au moins une couche réalisée dans une pérovskite inorganique ayant la composition sélectionnée.

Typiquement, le seuil précité peut être de 10 par exemple, notamment pour la famille à base de rubidium, précitée.

Dans une réalisation où une application photovoltaïque est visée par exemple, le procédé précité peut comporter plus particulièrement :
- Sélectionner une pluralité de compositions dont le nombre de modes de vibration à amplitude instable est inférieur à un seuil, et
- Estimer au moins une largeur de bande interdite de chaque composition pour sélectionner au moins une composition compatible avec une application photovoltaïque visée,
   En vue d'utiliser la composition compatible sélectionnée pour fabriquer un dispositif électronique de type photovoltaïque et comportant au moins une couche réalisée dans une pérovskite inorganique ayant ladite composition compatible.

Selon l'application visée pour la couche (de passivation ou à propriétés photovoltaïques), la valeur de son gap peut être le critère pour sélectionner la composition compatible, précitée.

Selon un autre aspect, il est visé aussi un programme informatique comportant des instructions pour mettre en œuvre le procédé ci-avant, lorsque ces instructions sont mises en œuvre par un processeur. Selon un autre aspect, il est proposé un support d'enregistrement non transitoire, lisible par un ordinateur, sur lequel est enregistré un tel programme informatique.

D'autres avantages et caractéristiques apparaitront à la lecture de la description détaillée d'exemples de réalisation ci-dessous, et à l'examen des dessins annexés sur lesquels :
- La figure 1 illustre une corrélation entre la stabilité de l'amplitude des modes de vibration des pérovskites inorganiques et leur facteur de Goldschmidt t,
- La figure 2 illustre les positions de sites atomiques dans une supercellule ayant 2 x 2 x 2 fois la taille de la maille primitive cubique (groupe d'espace *Pm*3̅*m*) d'une pérovskite de type ABX₃,
- La figure 3 illustre une approche algorithmique de sélection des meilleures pérovskites candidates en termes de stabilité,
- La figure 4 illustre l'évolution de l'énergie de la bande interdite avec la composition chimique d'une pérovskite de formule Cs(BₓB'₁₋ₓ)(X_{y}X'_{1-y})₃ (avec B = Ge, Sn et Pb, et X = Cl, Br et I),
- La figure 5 illustre le nombre de modes instables en fonction de la composition chimique d'une pérovskite de formule Cs(BₓB'₁₋ₓ)(X_{y}X'_{1-y})₃ (avec B = Ge, Sn et Pb, et X = Cl, Br et I),
- La figure 6a illustre l'évolution de l'énergie de la bande interdite avec la composition chimique d'une pérovskite de formule Rb(BₓB'₁₋ₓ)(X_{y}X'_{1-y})₃ (avec B = Ge, Sn et Pb, et X = Cl, Br et I),
- La figure 6b illustre le nombre de modes instables en fonction de la composition chimique d'une pérovskite de formule Rb(BₓB'₁₋ₓ)(X_{y}X'_{1-y})₃ (avec B = Ge, Sn et Pb, et X = Cl, Br et I),
- La figure 7 illustre schématiquement l'architecture classique n-i-p, d'une cellule photovoltaïque simple jonction comportant des couches minces usuelles de connexion et de collecte d'électrons ou de trous, mais comportant néanmoins et particulièrement une couche active à propriétés photovoltaïques réalisée dans un matériau de type ABX₃ où A=Cs ou Rb,
- La figure 8a et la figure 8b illustrent la variation du paramètre de maille moyen pour les pérovskites cubiques, respectivement de type Cs(BₓB'₁₋ₓ)(X_{y}X'_{1-y})₃ et Rb(BₓB'₁₋ₓ)(X_{y}X'_{1-y})₃, avec B = Ge, Sn et Pb, et X = Cl, Br et I,
- La figure 9a illustre l'évolution de l'énergie de bande interdite et du paramètre de maille pour divers composés de la famille CIGS, et la figure 9b illustre les efficacités théoriques maximales d'une cellule tandem, en fonction des énergies de bande interdite des couches constituant ces cellules,
- La figure 10 illustre l'évolution de l'énergie de bande interdite et du paramètre de maille pour divers composés III-V,
- La figure 11a illustre un diagramme d'orbitales représentant les combinaisons liantes et anti-liantes menant aux états proches de la bande interdite, et la figure 11b présente l'évolution théorique de la largeur de la bande interdite (ou « gap ») en fonction de la température, ici pour la pérovskite CsPbI₃, montrant une dépendance claire du gap à la température.

Dans la description qui suit, il est proposé de définir dans un premier temps la composition chimique de pérovskites halogénées inorganiques en optimisant leurs modes de vibration pour que la stabilité soit une propriété intrinsèque de ces matériaux.

A cet effet, il est proposé d'exploiter dans un premier temps des méthodes de modélisation atomique, basées sur les approches dites *ab-initio* (Density Functional Theory (DFT), fonctionnelles hybrides) respectant les premiers principes de la chimie quantique, afin d'étudier la stabilité des performances de différentes pérovskites inorganiques sous différentes contraintes, notamment la stabilité des modes de vibrations de ces matériaux qui guident leurs transitions de phases en température.

A la contrainte de stabilité sera ajoutée la contrainte d'utilisation pratique par exemple en cellule photovoltaïque. Typiquement dans le cadre du développement de technologies de cellules dites « tandem », ou encore de triples jonctions et des composés à grand gap, les matériaux doivent respecter différents critères :
- Avoir une bande d'énergie interdite (ou « gap ») compris entre 1.4 et 2.3 eV,
- Ne pas avoir de transitions de phase dans la gamme de température d'exploitation,
- Eventuellement avoir des propriétés optoélectroniques comparables aux matériaux de référence (afin de ne pas perturber les rendements des cellules).

Une première approche pour ce faire est la recherche de la stabilisation notamment de la phase cubique des pérovskites qui est l'une des phases communes à tous ces matériaux (la procédure décrite ici pouvant néanmoins être adaptée à toutes les phases).

L'un des facteurs d'instabilité de ces matériaux est leurs riches séquences de transitions de phase : elles sont souvent liées à l'existence de modes de vibrations ou phonons (modes « mous » ou « instables »). Il est proposé ci-après de définir la composition chimique de pérovskites inorganiques complexes afin de diminuer voire d'annihiler ces modes de vibration spécifiques tout en permettant d'apporter une description qualitative et quantitative des propriétés structurales, électroniques et optoélectroniques des matériaux obtenus.

Les 45 pérovskites inorganiques de base considérées pour définir les compositions chimiques optimales sont celles les plus couramment étudiées dans le domaine du photovoltaïque c'est-à-dire la formule générale ABX₃, avec :
A = Li, Na, K, Rb et Cs,
B = Ge, Sn et Pb et
X = Cl, Br et I.

Un hamiltonien a été défini par calcul afin de reproduire les propriétés structurales, électroniques, diélectriques des matériaux précédemment définis avec un bon accord avec l'expérience : Il combine 17,23 % d'échange dit « Hartree-Fock » à la fonctionnelle d'échange-corrélation dite « PBE » selon la référence :
J. Perdew et al., Physical Review Letters, 77, 3865 (1996).

Il s'avère que les erreurs moyennes obtenues sur les paramètres de maille et les bandes d'énergies des pérovskites CsBX₃ (donc avec A=Cs pour césium) sont de 2% et 10% par rapport aux données expérimentales disponibles. Ainsi, des calculs prédictifs à partir d'un hamiltonien peuvent effectivement être réalisés sur ces matériaux.

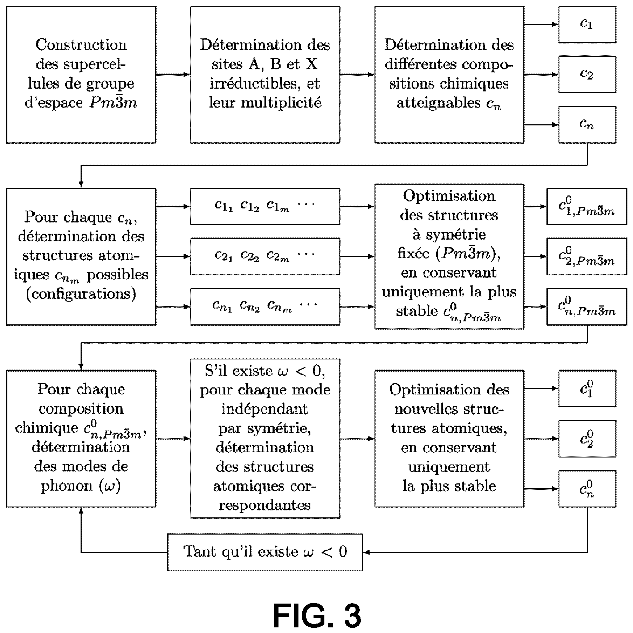

En référence à la figure 3 commentée plus loin, une approche dite « supercellule » a été utilisée alors afin de prendre en compte que les transitions de phase sont liées à l'existence de modes instables aux points G, X, R, et M de la zone de Brillouin, en considérant en particulier une taille de cette « supercellule » correspondant à 2 x 2 x 2 fois celle de la maille primitive cubique (groupe d'espace *Pm*3̅*m*) des ABX₃.

La nature des transitions de phase et la stabilité des pérovskites est généralement corrélée à un paramètre nommé « facteur de Goldschmidt » et noté « *t* » ci-après.

Habituellement il est considéré que si 0.8 < t < 1, la pérovskite est stable dans sa phase cubique. Or le tableau 1 montre que beaucoup de pérovskites vérifiant ce critère possèdent pourtant des modes instables. Ce critère n'est donc pas suffisant pour sélectionner les matériaux respectant le critère de stabilité recherché.

Le tableau 1 ci-dessous présente les facteurs de tolérance de Goldschmidt pour chaque composé pur, le critère C₁ correspondant au respect du critère expérimental 0.8 < t < 1 pour obtenir des pérovskites stables dans la phase cubique. Il présente aussi les k-points de haute symétrie de la première zone de Brillouin présentant des modes de phonons imaginaires. Le critère C₂ indique en revanche les composés dont la phase cubique est métastable d'un point de vue dynamique.

**Tableau 1 :**

| | ***t*** | ***C*₁** | ***k*-points avec des modes instables** | ***C₂*** |
|---|---|---|---|---|
| LiGeCl₃ | 0.760 | × | Γ, X, M, R | × |
| LiGeBr₃ | 0.757 | × | Γ, X, M, R | × |
| LiGeI₃ | 0.753 | × | Γ, X, M, R | × |
| LiSnCl₃ | 0.681 | × | Γ, X, M, R | × |
| LiSnBr₃ | 0.682 | × | Γ, X, M, R | × |
| LiSnI₃ | 0.684 | × | Γ, X, M, R | × |
| LiPbCl₃ | 0.643 | × | Γ, X, M, R | × |
| LiPbBr₃ | 0.646 | × | Γ, X, M, R | × |
| LiPbI₃ | 0.651 | × | Γ, X, M, R | × |
| NaGeCl₃ | 0.891 | ✔ | Γ, X, M, R | × |
| NaGeBr₃ | 0.881 | ✔ | Γ, X, M, R | × |
| NaGeI₃ | 0.866 | ✔ | Γ, X, M, R | × |
| NaSnCl₃ | 0.798 | × | Γ, X, M, R | × |
| NaSnBr₃ | 0.793 | × | Γ, X, M, R | × |
| NaSnI₃ | 0.787 | × | Γ, X, M, R | × |
| NaPbCl₃ | 0.754 | × | Γ, X, M, R | × |
| NaPbBr₃ | 0.752 | × | Γ, X, M, R | × |
| NaPbI₃ | 0.749 | × | Γ, X, M, R | × |
| KGeCl₃ | 0.960 | ✔ | Γ, X, M, R | × |
| KGeBr₃ | 0.946 | ✔ | Γ, X, M, R | × |
| KGeI₃ | 0.927 | ✔ | Γ, X, M, R | × |
| KSnCl₃ | 0.860 | ✔ | Γ, X, M, R | × |
| KSnBr₃ | 0.853 | ✔ | Γ, X, M, R | × |
| KSnI₃ | 0.842 | ✔ | Γ, X, M, R | × |
| KPbCl₃ | 0.813 | ✔ | Γ, X, M, R | × |
| KPbBr₃ | 0.808 | ✔ | Γ, X, M, R | × |
| KPbI₃ | 0.801 | ✔ | Γ, X, M, R | × |
| RbGeCl₃ | 0.983 | ✔ | Γ, X, M | × |
| RbGeBr₃ | 0.967 | ✔ | Γ, X, M | × |
| RbGeI₃ | 0.946 | ✔ | Γ, X, M, R | × |
| RbSnCl₃ | 0.880 | ✔ | Γ, M, R | × |
| RbSnBr₃ | 0.872 | ✔ | Γ, X, M, R | × |
| RbSnI₃ | 0.859 | ✔ | M, R | × |
| RbPbCl₃ | 0.832 | ✔ | M, R | × |
| RbPbBr₃ | 0.826 | ✔ | Γ, M, R | × |
| RbPbI₃ | 0.818 | ✔ | M, R | × |
| CsGeCl₃ | 1.027 | × | F, X, m | × |
| CsGeBr₃ | 1.009 | × | F, X, m | × |
| CsGeI₃ | 0.985 | ✔ | Γ, X, M | × |
| CsSnCl₃ | 0.920 | ✔ | Γ, X, M | × |
| CsSnBr₃ | 0.910 | ✔ | | ✔ |
| CsSnI₃ | 0.894 | ✔ | | ✔ |
| CsPbCl₃ | 0.870 | ✔ | M, R | × |
| CsPbBr₃ | 0.862 | ✔ | M, R | × |
| CsPbI₃ | 0.851 | J | M, R | × |

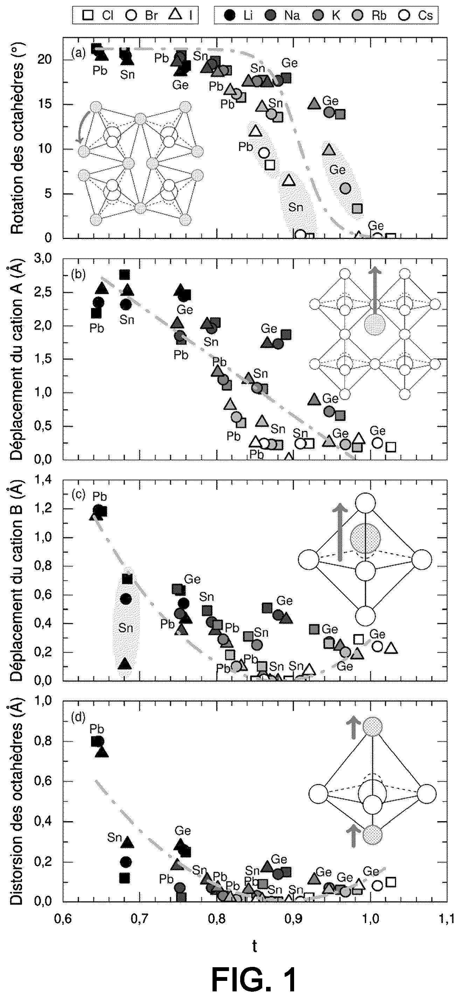

Pour sélectionner les matériaux pertinents pour la définition des compositions chimiques des pérovskites inorganiques complexes stables, le facteur t des différentes pérovskites a été corrélé à l'amplitude des déformations structurales les plus courantes lors des transitions de phase de ces matériaux, comme illustré sur la figure 1.

La figure 1 illustre en effet l'amplitude des différentes distorsions dans les pérovskites ABX₃ en fonction du facteur de Goldschmidt t , en particulier pour :
- la rotation des octaèdres formant la structure du matériau ABX₃ , en (a),
- le déplacement des cations A, en (b),
- le déplacement des cations B, en (c), et
- la distorsion de la longueur de liaison des octaèdres, en (d).

Il s'avère que la famille optimale par rapport à ces amplitudes de différentes distorsions est celle où le cation A est Cs (césium) ou Rb (rubidium).

Cette figure 1 montre en effet que seules les pérovskites qui minimisent les différences (les plus basses dans les courbes) sont les familles CsBX₃ et RbBX₃ (avec B = Ge, Sn et Pb, et X = Cl, Br et I). Le critère *t* vérifié par ces matériaux est : 0.875 < *t* < 0.925.

Ces deux familles sont donc sélectionnées pour optimiser la composition chimique de pérovskites complexes cubiques, de type ABₓB'₁₋ₓ(X_{y}X'_{1-y})₃ , afin de minimiser ou d'annihiler l'existence de modes instables. Pour affiner des déterminations pertinentes de x et y dans la composition ci-dessus, les étapes suivantes peuvent être menées :
a) La relaxation de chaque configuration de composés possible est étudiée pour sélectionner la structure la plus stable (minimisant l'énergie interne du matériau),
b) La valeur de gap est estimée pour déterminer si le matériau peut être approprié pour une application photovoltaïque,
c) Il est déterminé en outre si le matériau considéré présente des modes de phonons instables (modes de vibration à amplitude instable), et si tel n'est pas le cas,
d) Il est déterminé s'il est possible d'obtenir une ségrégation de phase, ce qui serait alors défavorable (détermination pouvant être basée sur une comparaison des enthalpies calculées pour les phases avec ségrégation et sans ségrégation), et si tel n'est pas le cas,
e) Une détermination plus fine est menée, notamment du gap, des propriétés optiques et électroniques, ainsi que du paramètre de maille du matériau pour déterminer notamment si un accord de maille peut être atteint avec des matériaux tel que le silicium pour des cellules multi-jonctions ou tandem avec du silicium par exemple, afin de modéliser une cellule photovoltaïque qui peut offrir des caractéristiques requises.

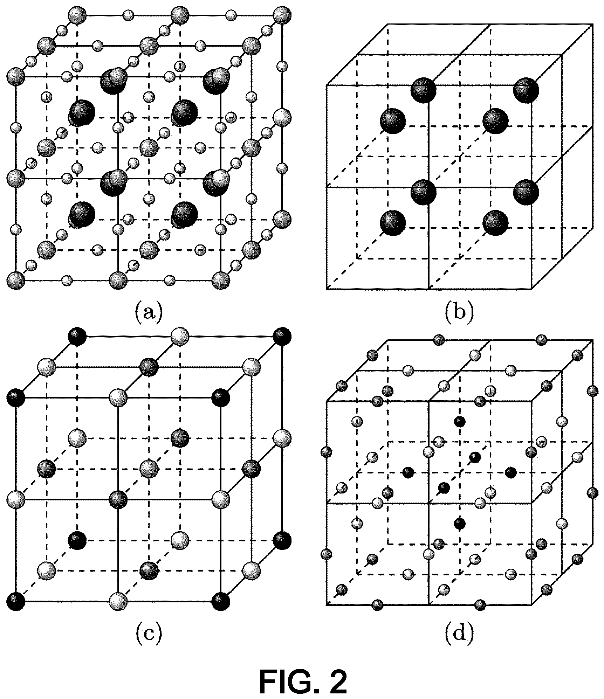

La figure 2 donne les sites de substitutions des ions A, B et X, pour appliquer l'étape a) ci-dessus afin d'optimiser et déterminer les phases dynamiquement stables pour chaque composition chimique. Pour étudier les propriétés d'une pérovskite complexe de type ABₓB'₁₋ₓ(X_{y}X'_{1-y})₃, 288 différentes compositions chimiques ont été explorées, ce qui correspond à 780 configurations atomiques différentes.

Plus particulièrement, il est représenté :
- les sites de substitution A, B et X dans une supercellule de type 2x2x2, en (a),
- les sites des cations A pour la symétrie *Pm*3̅*m* (positions atomiques indépendantes par opération de symétrie dans ce groupe d'espace *Pm*3̅*m*)*,* en (b),
- les sites des cations B pour cette symétrie *Pm*3̅*m,* en (c), et
- les sites des anions X pour cette symétrie *Pm*3̅*m,* en (d).

La figure 3 présente des étapes algorithmiques possibles pour sélectionner les meilleures compositions candidates en raison de leur stabilité. La figure 3 peut ainsi résumer les étapes d'un procédé du type présenté ci-avant, selon un exemple de réalisation. Elle peut aussi correspondre à l'ordinogramme d'un algorithme possible d'un programme informatique du type présenté en introduction ci-avant.

Ici, pour explorer les effets de la composition chimique des solutions solides de pérovskites sur leurs propriétés, une approche visant à considérer une supercellule de dimensions supérieures à une maille élémentaire a été appliquée. Une approche de ce type est détaillée notamment dans le document :
F. Lafond et al., dans the Journal of Physical Chemistry C, 124, 10353 (2020).

Pour chaque composition chimique « commensurable », tous les schémas de substitution non équivalents par symétrie ont été pris en compte. Il est en effet possible de générer plusieurs arrangements d'atomes qui donneraient une même composition chimique finale, mais sans pour autant disposer des mêmes propriétés. Pour chacun d'entre eux, les paramètres de maille et les coordonnées internes ont donc été optimisés, en maintenant la symétrie imposée par le schéma de substitution en question.

Pour chaque composition, seule la configuration permettant de minimiser l'énergie interne du système est conservée (la plus stable). Le calcul des phonons au point de haute symétrie Γy est effectué afin d'estimer la stabilité dynamique.

Dans le cas de l'existence de modes instables (ceux dont la fréquence est imaginaire), la symétrie a été réduite en conséquence et l'optimisation de la structure a été refaite pour permettre des déplacements correspondant au vecteur propre de phonon d'un tel mode instable. Dans la mesure où plusieurs modes de phonons imaginaires peuvent exister, et chacun pouvant mener à une réduction de l'ordre de symétrie différente (et donc à des distorsions différentes), chaque mode indépendant par symétrie est donc suivi, générant à nouveau plusieurs configurations pour une composition.

Pour chaque composition, la configuration la plus stable a été retenue pour l'optimisation structurelle ultérieure, suivie à nouveau du calcul des fréquences vibratoires (comme à l'étape précédente) pour l'analyse de la stabilité finale. La contribution des phonons (énergie du point zéro de la première zone de Brillouin) a ensuite été prise en compte pour l'évaluation finale de la stabilité relative des configurations.

On comprendra des commentaires de la figure 3 qui précèdent que la répartition des cations B et/ou des anions X dans les sites du réseau cristallin *Pm3m* (déterminant une stœchiométrie à respecter) permet de déterminer des configurations offrant une stabilité recherchée en termes de modes de vibration (annihilant les modes instables ou limitant le nombre de modes instables à une valeur inférieure à un seuil). On retient ci-après que la composition chimique (avec une stœchiométrie précise) des pérovskites permet alors de faire décroître le nombre de modes instables que peuvent posséder ces matériaux.

Il a été observé déjà que seules les pérovskites à base de césium CsBₓB'₁₋ₓ(X_{y}X'_{1-y})₃ peuvent posséder des compositions chimiques permettant de faire disparaître complètement l'existence de modes instables. Il a été observé aussi que les pérovskites à base de rubidium (Rb) présentaient des gammes de compostions globalement à faibles nombres de modes instables.

On comprendra alors que la précision d'une composition particulière de pérovskite (détermination de valeurs optimales pour x et y dans ABₓB'₁₋ₓ(X_{y}X'_{1-y})₃, avec A = Cs ou Rb) permet en premier lieu de faire décroître le nombre de modes instables que peuvent posséder ces matériaux, mais d'atteindre par ailleurs une propriété souhaitée (par exemple une valeur de gap, un accord de maille, ou autres) en fonction d'un contexte d'application donné (pour des applications photovoltaïques typiquement).

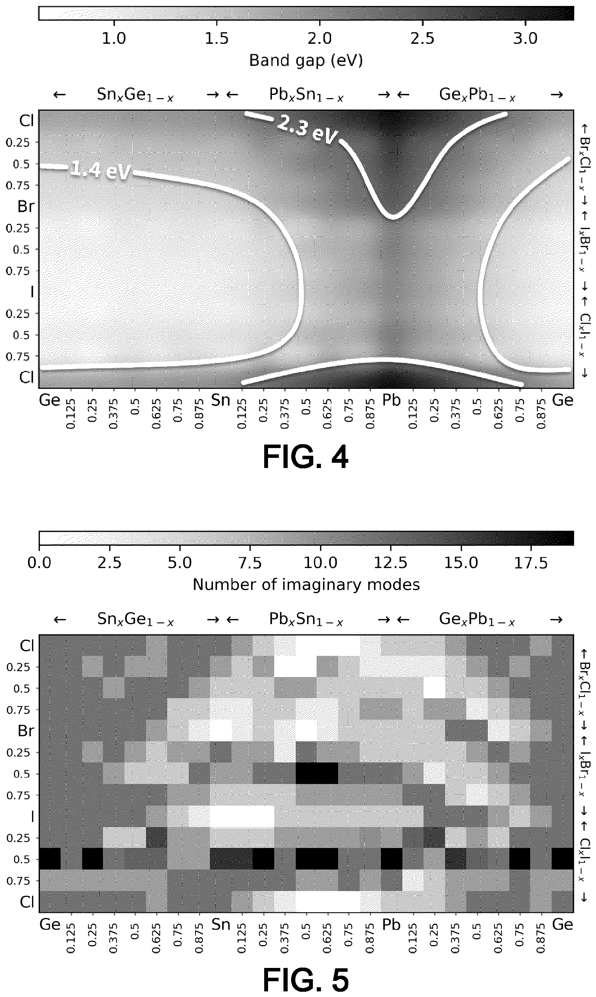

On a représenté sur la figure 4 l'évolution de l'énergie de la bande interdite (ou « gap ») avec la composition chimique pour la maille cubique. Bien que cette énergie puisse évoluer avec les transitions de phase, cette figure est une base pertinente pour choisir les compositions chimiques ayant une bande d'énergie interdite donnée en fonction de la technologie souhaitée pour les applications liées au photovoltaïque.

Plus particulièrement, la figure 4 présente l'énergie de bande interdite pour les pérovskites cubiques de type Cs(BₓB'₁₋ₓ)(X_{y}X'_{1-y})₃ (avec B = Ge, Sn et Pb, et X = Cl, Br et I). Les limites des énergies de bande interdite d'intérêt pour le photovoltaïque sont rappelées par les lignes 1.4eV et 2.3eV représentées en blanc.

La figure 5 donne par ailleurs l'évolution du nombre de modes instables. Plus particulièrement, la figure 5 présente l'influence de la composition chimique des pérovskites de type Cs(BₓB'₁₋ₓ)(X_{y}X'_{1-y})₃ (avec B = Ge, Sn et Pb, et X = Cl, Br et I) sur le nombre de modes instables dans le matériau. Ainsi typiquement, il convient de croiser des compositions candidates relativement à un gap recherché en utilisant la nappe de la figure 4 avec le nombre de modes instables selon la nappe de la figure 5 pour vérifier qu'une composition candidate en raison de son gap puisse être stable ou non.

Le tableau 2 ci-après présente à titre d'exemple neuf compositions chimiques de différentes pérovskites inorganiques complexes de type Cs(BₓB'₁₋ₓ)(X_{y}X'_{1-y})₃ qui ne possèdent pas de modes instables, avec :
- leur facteur de Goldschmidt (t),
- leur bande d'énergie interdite (E_{g} en eV),
- leur constante diélectrique électronique (**e**_{∞}) et entre parenthèses l'indice de réfraction correspondant (n),
- ainsi que leur constante diélectrique statique (e).

Ces composés ont tous un facteur t égal à (ou voisin) de 0,9, confirmant ainsi de meilleurs résultats relativement aux compositions du tableau 1 ci-avant.

**Tableau 2**

| **Composition** | ***t*** | **E_{g}** | e_{∞} (n) | **e** |
|---|---|---|---|---|
| CsGe_{0.25}Pb_{0.75}(Br_{0.5}Cl_{0.5})₃ | 0.90 | 2.32 | 3.66 (1.91) | 123. |
| CsPb_{0.125}Sn_{0.875}I₃ | 0.89 | 1.13 | 5.89 (2.43) | 387. |
| CsPb_{0.25}Sn_{0.75}I₃ | 0.88 | 1.26 | 5.59 (2.36) | 487. |
| CsPb_{0.375}Sn_{0.625}(Br_{0.25}Cl_{0.75})₃ | 0.90 | 1.88 | 3.66 (1.91) | 16. |
| CsPb_{0.5}Sn_{0.5}(Br_{0.25}Cl_{0.75})₃ | 0.89 | 1.94 | 3.59 (1.89) | 208. |
| CsPb_{0.5}Sn_{0.5}Br₃ | 0.88 | 1.93 | 4.06 (2.01) | 28. |
| CsPb_{0.5}Sn_{0.5}Cl₃ | 0.89 | 2.59 | 3.23 (1.80) | 32. |
| CsPb_{0.625}Sn_{0.375}Cl₃ | 0.89 | 2.71 | 3.15 (1.77) | 31. |
| CsPb_{0.75}Sn_{0.25}Cl₃ | 0.88 | 2.86 | 3.08 (1.75) | 7. |

Si certains des matériaux du tableau 1 pouvaient présenter des modes instables, il a bien été observé pour l'élaboration de ce tableau 2 une corrélation claire entre la stabilité des matériaux obtenus et leur facteur de Goldschmidt t (ici égal ou voisin de 0,9).

Il apparait typiquement que la famille de composition Cs(PbₓSn₁₋ₓ)(Br_{y}Cl_{1-y}) présente des valeurs de gap comprises entre 1,4 et 2,3eV avantageusement compatibles avec des applications photovoltaïques, pour autant que x et y soient judicieusement choisis entre 0 et 1 et sans risque d'obtenir des modes instables selon la figure 5 commentée plus loin.

Ainsi, il est possible de moduler la composition x,y dans une formulation donnée pour affiner par exemple des propriétés de gap ou d'accord de maille recherchées.

D'autres propriétés encore peuvent être recherchées : par exemple, la constante diélectrique statique de la composition CsPbₓSn₁₋ₓ(Br_{0.25}Cl_{0.75})₃ diffère significativement selon que x=0,375 ou que x=0,5 (pour laquelle le matériau peut trouver à s'appliquer si des effets super-capacitifs sont recherchés).

Bien que les pérovskites à base de rubidium de type RbBₓB'₁₋ₓ(X_{y}X'_{1-y})₃ ne possèdent pas de composition chimique sans modes instables (ces modes étant toutefois en nombre très limité pour cette famille de matériau), les énergies de bandes interdites sont intéressantes pour des applications photovoltaïques comme le montrent :

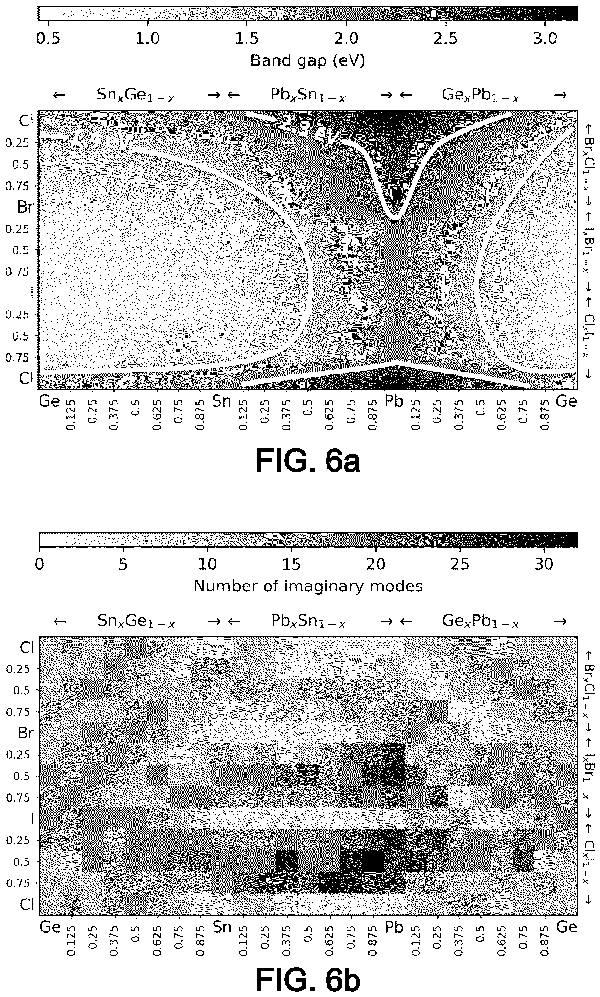

- La figure 6a, illustrant l'énergie de bande interdite estimée en fonction des paramètres x et y dans la composition Rb(BₓB'₁₋ₓ)(X_{y}X'_{1-y})₃ avec B = Ge, Sn et Pb, et X = Cl, Br et I, les limites des énergies de bande interdite d'intérêt pour les applications photovoltaïques étant représentées en blanc ; et
- La figure 6b, illustrant le nombre de modes de phonons instables pour les pérovskites cubiques Rb(BₓB'₁₋ₓ)(X_{y}X'_{1-y})₃ (avec B = Ge, Sn et Pb, et, X = Cl, Br et I).

A l'instar des pérovskites à base de césium, bien que cette énergie de bande interdite puisse évoluer avec les transitions de phase, la figure 6a constitue une base pertinente pour choisir les compositions chimiques ayant une bande d'énergie interdite donnée en fonction de la technologie souhaitée pour les applications liées au photovoltaïque.

En outre, comparativement à la figure 5, on peut observer que la nappe de la figure 6b pour la pérovskite à base de Rb est moins contrastée que celle à base de Cs. La figure 6b présente en effet des variations plus progressives du nombre de modes instables en fonction des compositions x,y. Ainsi, il est possible de chercher un matériau candidat autour d'une composition donnée par rapport à son gap pour permettre d'affiner la valeur de gap souhaitée (ou le paramètre de maille souhaité par exemple) avec une prédictibilité raisonnable sur la stabilité du matériau.

Typiquement en référence à la figure 6b, trois bandes horizontales claires apparaissent pour les compositions :
- Rb(PbₓSn₁₋ₓ)Cl₃ avec x compris entre 0,4 et 1,
- Rb(PbₓSn₁₋ₓ)Br₃ avec x compris entre 0 et 0,7,
- Rb(PbₓSn₁₋ₓ)I₃ avec x compris entre 0 et 0,8.

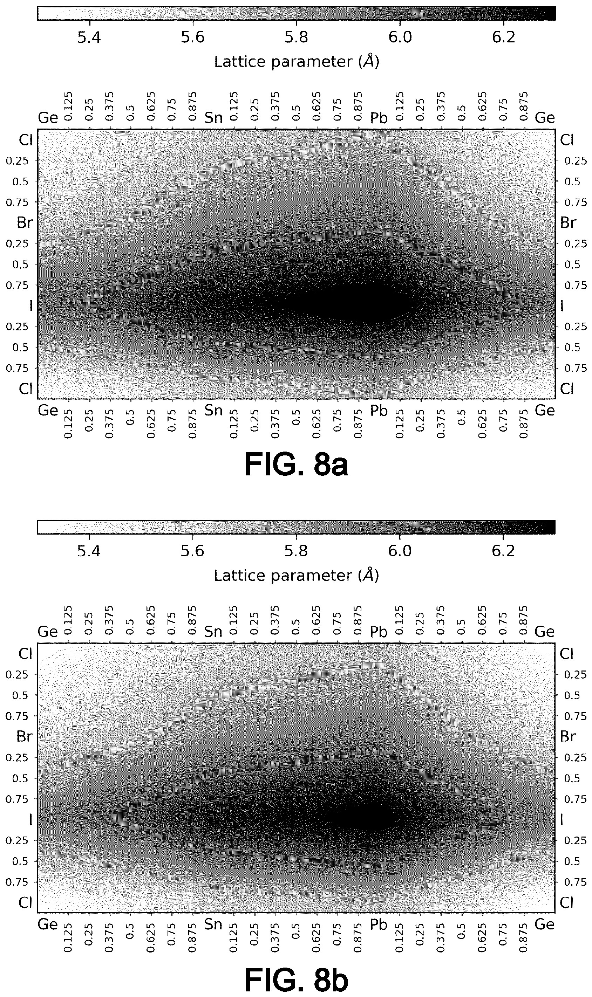

La composition Rb(PbₓSn₁₋ₓ)Cl₃ ne convient pas pour une couche photovoltaïque en raison de son incompatibilité de gap (trop haut) mais pourrait servir pour la fabrication d'une couche de passivation. Les deux autres compostions à base de Br et I permettent de choisir différentes valeurs de gap possibles, mais seule la composition Rb(PbₓSn₁₋ₓ)Br₃ offre un accord de maille acceptable avec le silicium pour l'utiliser en cellule tandem avec ce matériau (comme le montre la figure 8b commentée plus loin). Cette composition Rb(PbₓSn₁₋ₓ)Br₃, avec x compris entre 0 et 0,7, offre une large gamme de gaps possibles, et ce en compatibilité avec une couche de silicium pour fabriquer une cellule tandem.

Les applications potentielles dans d'autres domaines que le photovoltaïque restent les mêmes que celles pour les pérovskites à base de césium, si notamment des effets super-capacitifs sont recherchés.

Dans le domaine d'application d'un dispositif photovoltaïque au sens large, en fonction de leurs bandes d'énergie interdite, ces matériaux à base de pérovskites de compositions ainsi optimisées peuvent être utilisés aussi bien comme « absorbeurs » (couche active à propriétés photovoltaïques dans une cellule photovoltaïque), ou encore en tant que couches de passivation, ou autres, et ce pour différentes technologies possibles de cellules photovoltaïques (tandem, multi-jonctions, ou autres).

Typiquement :
- Les matériaux possédant des gaps entre 1eV et 1.3 eV peuvent être considérés comme des alternatives au silicium et intervenir dans des cellules de type « simple jonction »,
- Les matériaux possédant des gaps entre 1.3 eV et 1.8 eV peuvent être considérés pour des cellules photovoltaïques de type « tandem » comme les cellules Si/pérovskites ou CIGS/pérovskites,
- Les matériaux possédant des bandes interdites > 1.8 eV peuvent être considérés comme matériaux de couches de passivation pour les différentes cellules photovoltaïques transparentes au rayonnement solaire.

Comme présenté ci-avant, certains de ces matériaux peuvent posséder de hautes constantes diélectriques (>> 10) ce qui élargit leurs applications à des domaines comme l'optoélectronique, la microélectronique pour des usages pouvant être associés à la piézoélectricité (capteur ou émetteur piézoélectrique) ou le stockage diélectrique de l'énergie haute densité (comme les hyper-condensateurs ou supercondensateurs). Une autre application encore est la photocatalyse (pour la réduction du CO₂ par exemple).

Il est présenté et détaillé néanmoins ci-après deux applications principales dans le domaine photovoltaïque.

Une première application est la fabrication d'une cellule à jonction unique à base de pérovskites inorganiques de type A(BₓB'₁₋ₓ)(X_{y}X'_{1-y})₃ avec A=Cs ou Rb, B = Ge, Sn et Pb, et X = Cl, Br et I, avec une composition x,y adéquate comme l'une des neuf compositions du tableau 2 par exemple.

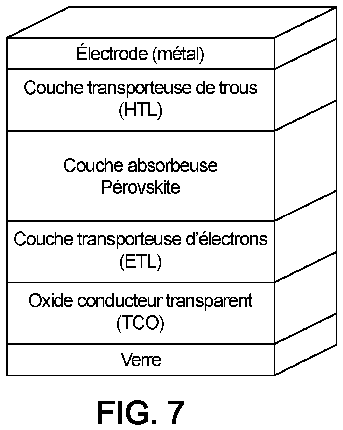

A cet effet, une architecture fréquemment utilisée est de type « classique » n-i-p, comme représenté en Figure 7 (la couche extractrice d'électrons étant alors placée au plus proche du substrat généralement en verre). Le substrat de verre et d'oxide conducteur transparent (ou « TCO », qui sert de contact « bottom ») peuvent être achetés préassemblés et nettoyés. Le TCO le plus fréquemment utilisé dans cette architecture est le FTO (pour *« fluorine-doped tin oxide* »). Le nettoyage du substrat se fait dans un bain à ultrasons à température ambiante, en utilisant plusieurs solvants (acétone, eau déminéralisée, ou autre), et par la suite avec un rayonnement ultraviolet.

Est ensuite déposée sur la couche TCO une couche transporteuse d'électrons (ETL). Le plus souvent, cette couche est composée de matériaux inorganiques permettant :
- une bonne transmission de la lumière,
- un alignement de bande favorable avec la bande de conduction de la pérovskite (et bloquant le passage des trous), et
- une bonne mobilité des électrons.

A ce titre, de nombreux candidats existent, les plus couramment utilisés étant SnO₂, TiO₂ et ZnO.

Ceux-ci sont déposés sous la forme d'une solution formant une couche homogène, pouvant postérieurement subir un recuit à une centaine de degrés pendant une trentaine de minutes. Est ensuite déposée sur cette couche, la couche d'absorbeur comportant la pérovskite sélectionnée. Cette couche peut être déposée en préparant d'abord un mélange des précurseurs AX et BX₂ (sous forme de sel), dans des proportions permettant de reproduire la solution solide souhaitée. Les sels sont solubilisés dans des solvants organiques (tels que NMP, DMF, DMSO) à température ambiante, et on atteint au sein de la solution une concentration de l'ordre de 1 mol/L. Des additifs, tels que FAAc, peuvent être ajoutés à la solution afin de permettre une meilleure cristallinité.

La couche pérovskite obtenue a alors une épaisseur en général comprise entre 100 et 500 nm. Pendant le dépôt, peu importe la méthode choisie, un flux de diazote est soufflé sur le substrat pour sécher la couche et évaporer le solvant. Le dépôt se suit d'un recuit à une centaine de degrés pour évaporer les dernières traces de solvant. Une étape supplémentaire de recuit peut être requise à plus haute température (340°C) pour retirer les dernières traces d'additif (si celui-ci a été ajouté).

La pérovskite peut être formée de plusieurs manières : sous la forme de nanocristaux, de monocristaux, de polycristaux.

Enfin, est déposée sur cette couche la couche transporteuse de trous (HTL) (par-dessus la pérovskite). Celle-ci peut être composée de spiro-OMeTAD, PTAA, NiOₓ, CuSCN, CuI, ou autres. Elle doit permettre, par son alignement de bandes, le passage des trous et le blocage des électrons, ainsi qu'une bonne mobilité des trous. A la suite de son dépôt, un recuit à une centaine de degrés est effectué.

La méthode de dépôt des différentes couches entre les électrodes peut être identique, ou différente. Dans un souci d'industrialisation, il peut être préférable de considérer la même méthode. Parmi ces méthodes, plusieurs peuvent être considérées, à savoir :
- Le dépôt par « spin coating », ou par
- « Blade coating », ou par
- « Slot-die coating », ou encore
- Par jet d'encre ou « Inkjet printing »

Chacune de ces méthodes, après calibration, permet d'obtenir des couches de profondeurs spécifiques.

Ces méthodes de dépôt sont en général effectuées en environnement contrôlé (en « boîte à gants »), mais peuvent aussi être réalisés en salle sèche (avec un taux d'humidité aux alentours de 20%) ou plus rarement, à l'air libre.

Enfin, une dernière couche de contact (« top ») est ajoutée par évaporation thermique. Il s'agit en général d'un métal bon conducteur (comme l'or, l'argent ou le cuivre). La cellule peut alors être encapsulée.

La figure 7 illustre schématiquement l'architecture classique n-i-p, d'une cellule photovoltaïque avec des couches du type précité. Le verre (substrat de base) se situe en bas (sous le TCO). En fonctionnement, la cellule solaire reçoit la lumière par le bas de l'architecture montrée ici.

Une architecture de type « inversée » p-i-n peut aussi être réalisée, en commençant par un substrat verre + ITO (*indium-doped tin oxide*)*,* puis en déposant les couches de transport de trous, d'absorbeur et de transport d'électrons selon les mêmes méthodes évoquées précédemment.

Une deuxième application possible est la fabrication d'une cellule tandem combinant ce matériau pérovskite et une couche de silicium.

L'architecture utilisée est celle d'une cellule tandem dite à deux terminaux, où il existe un couplage électrique entre les deux absorbeurs.

La cellule « basse » peut être achetée préassemblée. Celle-ci peut se composer de silicium, mais d'autres matériaux peuvent aussi être envisagés (tels que les matériaux « CIGS »). La couche d'absorbeur en silicium a généralement une épaisseur de quelques centaines de micromètres. La surface de dépôt est nettoyée avec de l'éthanol par spin coating ainsi que par rayonnement ultraviolet. Une couche de recombinaison transparente (généralement IZO, indium-doped zinc oxide) est déposée par-dessus. Les couches de HTL, pérovskite, ETL, sont ajoutées à la suite, en suivant le mode opératoire détaillé précédemment pour une cellule à simple jonction. On ajoute un contact, et finalement une couche anti-reflet.

Il peut être mis en œuvre aussi la synthèse d'une cellule à quatre terminaux en suivant le même mode opératoire que précédemment : chaque cellule est fabriquée indépendamment, les deux tandems sont ensuite assemblés. Les contacts entre les deux couches d'absorbeurs alors ajoutées (par rapport au modèle 2-terminaux) doivent être transparentes pour permettre le fonctionnement des deux cellules indépendantes (silicium et pérovskite, respectivement). L'alignement du paramètre de maille entre la pérovskite et les couches à son interface est aussi retenu comme critère de sélection. Les paramètres de maille moyens dans les pérovskites cubiques A(BB')(XX')₃ sont présentés en figures 8a et 8b. Ces valeurs des figures 8a et 8b sont à comparer avec la valeur du paramètre de maille du silicium qui est de 0,543 nm. En outre, une tolérance d'écart de maille par exemple de 2% (sans couche tampon) reste acceptable pour obtenir un empilement de couches pérovskite/silicium avec un nombre de dislocations suffisamment limité pour ne pas nuire aux propriétés photovoltaïques de la cellule.

De manière plus générale, il est possible de prévoir un matériau à base de pérovskite, stable, de gap choisi et surtout de maille choisie, pour pouvoir recevoir un dépôt ou être déposé sur un deuxième matériau, par exemple pour des applications de cellules tandem ou multi-jonctions.

Ainsi, la présente description vise aussi un dispositif électronique, de type photovoltaïque et comportant une première couche d'un premier matériau et une deuxième couche d'un deuxième matériau. Le deuxième matériau comporte une pérovskite inorganique à propriétés photovoltaïques ayant :
- un facteur de Goldschmidt t compris entre 0,87 et 0,93,
- une largeur de bande interdite choisie, et
- une composition choisie pour un accord de maille avec le premier matériau.

Ainsi, la première et la deuxième couchée sont déposées directement l'une sur l'autre (sans nécessiter typiquement de couche tampon intermédiaire, d'adaptation de maille entre les deux matériaux).

Plus particulièrement, outre le respect de la gamme ci-dessus du facteur de Goldschmidt, en termes de stabilité, la pérovskite inorganique comporte un nombre de modes de vibration instables inférieur à un seuil (après une étude phononique du type illustré notamment sur la figure 5 comme décrit ci-avant, ou encore la figure 6b).

Ce seuil dépend bien entendu du nombre de pérovskites candidates qu'il est possible d'obtenir. Typiquement, il est possible de ne retenir qu'une seule pérovskite : celle qui présente le nombre de modes de vibration instables le plus bas. Si plusieurs pérovskites candidates sont possibles quant à ce critère, il est possible de sélectionner ensuite celle qui est la moins polluante ou la plus économique de fabrication, etc.

A titre d'exemples supplémentaires que l'accord de maille avec le silicium présenté ci-avant, on peut citer ci-après un accord de maille sur d'autres matériaux tels qu'un alliage CIGS (C pour cuivre, I,G pour indium et/ou gallium, et S pour sélénium et/ou soufre), ou encore un accord de maille sur un matériau III-V (type GaAs, InP, ou autre).

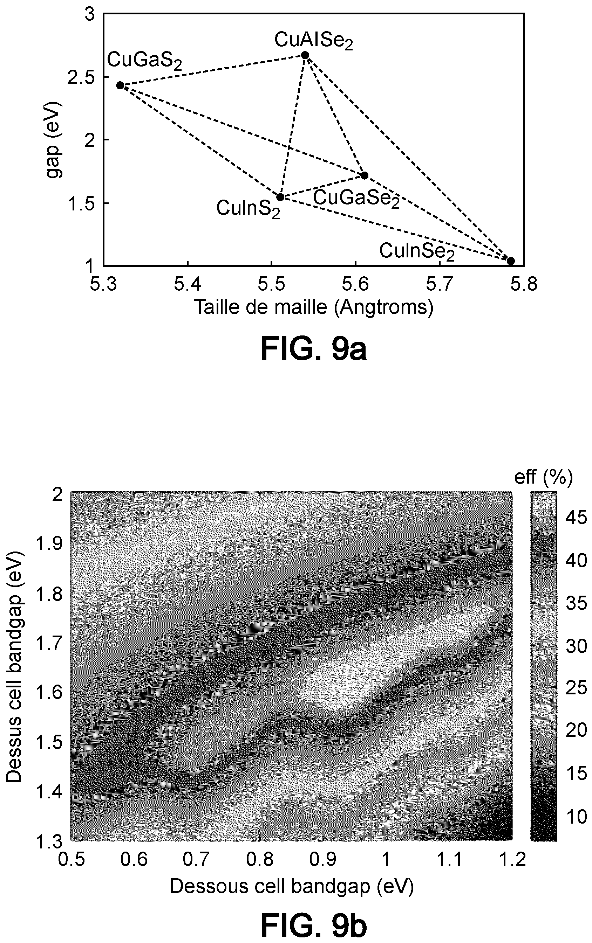

Pour le CIGS typiquement, les valeurs de largeur de bande interdite des matériaux de la famille CIGS sont données en figure 9a. En fonction du composé choisi, on peut le placer en cellule haute ou basse dans la configuration tandem. Jusqu'à la composition CuInS₂, la largeur de bande interdite ou « gap » ci-après est assez faible et on place la pérovskite en cellule haute. Au-delà de cette composition, il vaut mieux choisir une pérovskite de gap bas et la placer en cellule basse.

Il convient alors de choisir une pérovskite qui puisse satisfaire à la fois les critères d'accord de maille, mais aussi de largeur de bande interdite permettant d'optimiser l'efficacité du module, comme rappelé par la figure 9b. Pour les matériaux CIGS à haut gap (se situant entre 1.5 et 2.5 eV), on peut noter que leur paramètre de maille est faible (entre 5.3 et 5.6 Å). Il convient alors de choisir une pérovskite respectant à la fois le paramètre de maille, et ayant un petit gap (inférieur à 1.5eV).

Les pérovskites sont triées en fonction de leur paramètre de maille, et données dans le tableau ci-après (par paramètre de maille croissant, en deuxième colonne) pour le matériau usuel CuGaSe₂, tout d'abord. Le gap est indiqué en troisième colonne et le nombre de modes de vibration instables et aussi indiqué en quatrième et dernière colonne. Toutes les pérovskites candidates qui y sont indiquées vérifient en outre la restriction quant au facteur de Goldschmidt qui doit être compris entre 0,87 et 0,93.

### Compositions de pérovskites inorganiques adaptées pour tandem Pérovskite sur CuGaSe₂

| **Pérovskite** | **a (Å)** | **E_{g} (eV)** | **Nᵢₘ** |
|---|---|---|---|
| RbGe_{0.5}Sn_{0.5}(Cl_{0.75}I_{0.25})₃ | 5.632 | 0.981 | 15 |
| RbGe_{0.625}Pb_{0.375}(Cl_{0.75}I_{0.25})₃ | 5.634 | 1.034 | 15 |
| RbGe_{0.5}Sn_{0.5}(Cl_{0.25}Br_{0.75})₃ | 5.642 | 1.136 | 15 |

Dans ce tableau, on n'a retenu que les pérovskites de tailles de maille compatibles (à plus ou moins 1% près) avec celles de l'autre matériau de la cellule tandem qui a la taille de maille la plus petite dans l'alliage usuel CuGaₓIn₁₋ₓSe₂ (avec x compris entre 0 et 1, compris), qui est donc ici CuGaSe₂.

Typiquement les pérovskites qui conviennent le mieux par rapport à la taille de maille la plus proche de celle de CuGaSe₂ (à plus ou moins 1% près) sont :

RbGe_{0.5}Sn_{0.5}(Cl_{0.75}I_{0.25})₃

RbGe_{0.625}Pb_{0.375}(Cl_{0.75}I_{0.25})₃

RbGe_{0.5}Sn_{0.5}(Cl_{0.25}Br_{0.75})₃

Elles présentent néanmoins un nombre de modes de vibration instables relativement élevé (15) par rapport aux autres compositions ci-après dans d'autres configurations de cellules qui pourraient être préférées pour cette raison.

En suivant un raisonnement similaire pour les matériaux CIGS à faible gap, on peut sélectionner des compositions permettant d'avoir un paramètre de maille se situant entre 5.5 et 5.8 Å, et un gap situé entre 1.5 et 2.3 eV pour une efficacité optimale.

Ensuite, parmi ces pérovskites candidates, on peut sélectionner celles ayant un nombre de modes de vibration instables inférieur à 10. Ainsi, le seuil du nombre de modes de vibration instables pour sélectionner des pérovskites selon leur critère de stabilité phononique peut être choisi, et ci-après dans les exemples, il est choisi à 10.

Les pérovskites possibles selon ces critères (tailles a de maille compatibles, gaps Eg dans la gamme convenant, nombre Nim de modes inférieur à 10) sont données dans le tableau suivant.

### Compositions de pérovskites inorganiques adaptées pour tandem CIGS sur Pérovskite

| **Pérovskite** | **a (Å)** | **E_{g} (eV)** | **Nᵢₘ** |
|---|---|---|---|
| RbGe_{0.125}Sn_{0.875}Cl₃ | 5.569 | 1.796 | 9 |
| RbGe_{0.25}Sn_{0.75}(Cl_{0.75}Br_{0.25})₃ | 5.593 | 1.502 | 9 |
| RbSnCl₃ | 5.602 | 1.896 | 9 |
| RbGe_{0.5}Pb_{0.5}(Cl_{0.25}Br_{0.75})₃ | 5.7 | 1.651 | 9 |
| RbGe_{0.375}Pb_{0.625}(Cl_{0.25}Br_{0.75})₃ | 5.744 | 1.899 | 6 |
| RbGe_{0.5}Pb_{0.5}Br₃ | 5.755 | 1.718 | 6 |
| CsSn_{0.875}Pb_{0.125}Cl₃ | 5.66 | 2.139 | 9 |
| CsSn_{0.75}Pb_{0.25}Cl₃ | 5.673 | 2.279 | 6 |
| CsGe_{0.375}Pb_{0.625}(Cl_{0.75}Br_{0.25})₃ | 5.675 | 2.295 | 6 |
| CsSn(Cl_{0.75}Br_{0.25})₃ | 5.714 | 1.658 | 9 |
| CsSn_{0.875}Pb_{0.125}(Cl_{0.75}Br_{0.25})₃ | 5.726 | 1.723 | 6 |
| CsGe_{0.375}Pb_{0.625}(Cl_{0.5}Br_{0.5})₃ | 5.736 | 2.195 | 6 |
| CsGe_{0.125}Sn_{0.875}(Cl_{0.5}Br_{0.5})₃ | 5.74 | 1.507 | 9 |
| CsSn_{0.75}Pb_{0.25}(Cl_{0.75}Br_{0.25})₃ | 5.742 | 2.043 | 9 |
| CsSn_{0.625}Pb_{0.375}(Cl_{0.75}Br_{0.25})₃ | 5.749 | 1.884 | 0 |
| CsSn_{0.5}Pb_{0.5}(Cl_{0.75}Br_{0.25})₃ | 5.761 | 1.936 | 0 |
| CsSn(Cl_{0.5}Br_{0.5})₃ | 5.777 | 1.597 | 6 |
| CsSn_{0.875}Pb_{0.125}(Cl_{0.5}Br_{0.5})₃ | 5.788 | 1.677 | 6 |
| CsSn_{0.25}Pb_{0.75}(Cl_{0.75}Br_{0.25})₃ | 5.788 | 2.299 | 6 |
| CsGe_{0.375}Pb_{0.625}(Cl_{0.25}Br_{0.75})₃ | 5.791 | 2.008 | 9 |
| CsGe_{0.375}Pb_{0.625}(Cl_{0.75}I_{0.25})₃ | 5.797 | 1.616 | 9 |
| CsSn_{0.75}Pb_{0.25}(Cl_{0.5}Br_{0.5})₃ | 5.799 | 1.763 | 6 |

Typiquement encore selon ces résultats, du CuInSe₂ (alliage usuel) peut être déposé directement sur les pérovskites suivantes, avec accord de maille (avec ici plus ou moins 1% d'écart au maximum) :
RbGe_{0.375}Pb_{0.625}(Cl_{0.25}Br_{0.75})₃, RbGe_{0.5}Pb_{0.5}Br₃, CsSn_{0.875}Pb_{0.125}(Cl_{0.75}Br_{0.25})₃, CsGe_{0.375}Pb_{0.625}(Cl_{0.5}Br_{0.5})₃, CsGe_{0.125}Sn_{0.875}(Cl_{0.5}Br_{0.5})₃, CsSn_{0.75}Pb_{0.25}(Cl_{0.75}Br_{0.25})₃, CsSn_{0.625}Pb_{0.375}(Cl_{0.75}Br_{0.25})₃, CsSn_{0.5}Pb_{0.5}(Cl_{0.75}Br_{0.25})₃, CsSn(Cl_{0.5}Br_{0.5})₃, CsSn_{0.875}Pb_{0.125}(Cl_{0.5}Br_{0.5})₃, CsSn_{0.25}Pb_{0.75}(Cl_{0.75}Br_{0.25})₃, CsGe_{0.375}Pb_{0.625}(Cl_{0.25}Br_{0.75})₃, CsGe_{0.375}Pb_{0.625}(Cl_{0.75}I_{0.25})₃, CsSn_{0.75}Pb_{0.25}(Cl_{0.5}Br_{0.5})₃

Si une sélection doit être encore opérée par rapport au nombre de modes de vibration instables, on peut retenir les pérovskites suivantes qui ont un tel nombre inférieur ou égal à 6 :
RbGe_{0.375}Pb_{0.625}(Cl_{0.25}Br_{0.75})₃, RbGe_{0.5}Pb_{0.5}Br₃, CsSn_{0.875}Pb_{0.125}(Cl_{0.75}Br_{0. 25})₃, CsGe_{0.375}Pb_{0.625}(Cl_{0.5}Br_{0.5})₃, CsSn_{0.625}Pb_{0.375}(Cl_{0.75}Br_{0.25})₃, CsSn_{0.5}Pb_{0.5}(Cl_{0.75}Br_{0.25})₃, CsSn(Cl_{0.5}Br_{0.5})₃, CsSn_{0.875}Pb_{0.125}(Cl_{0.5}Br_{0.5})₃, CsSn_{0.25}Pb_{0.75}(Cl_{0.75}Br_{0.25})₃, CsSn_{0.75}Pb_{0.25}(Cl_{0.5}Br_{0.5})₃

Pour s'assurer d'une stabilité totale, on peut ne retenir que CsSn_{0.625}Pb_{0.375}(Cl_{0.75}Br_{0.25})₃ et CsSn_{0.5}Pb_{0.5}(Cl_{0.75}Br_{0.25})₃, qui sont dépourvues totalement de mode de vibration instable.

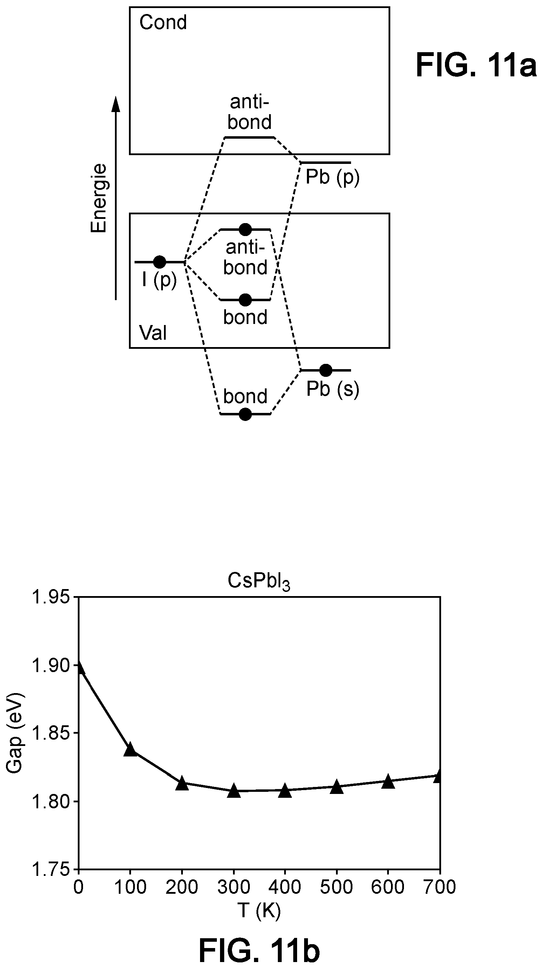

Il convient d'insister sur le fait que ces pérovskites sont stables, tant sur le plan de leur structure (après élimination des candidats à haut nombre de modes de vibration instables d'après une étude phononique du type illustré sur la figure 5 ou la figure 6b) que sur le plan de leur gap (comme notamment développé plus loin en référence aux figures 11a et 11b).

Pour déterminer les compositions qui conviendraient le mieux à un alliage quaternaire de type CIGS où S est du sélénium seulement par exemple, il convient de déterminer la taille de maille de l'alliage CIGS en question et de sélectionner les candidats qui ont la taille de maille la plus proche selon le même raisonnement ci-dessus. Le gap est alors donné par une table de même nature pour apprécier l'efficacité de la cellule tandem ou multi-jonctions qui peut en résulter.

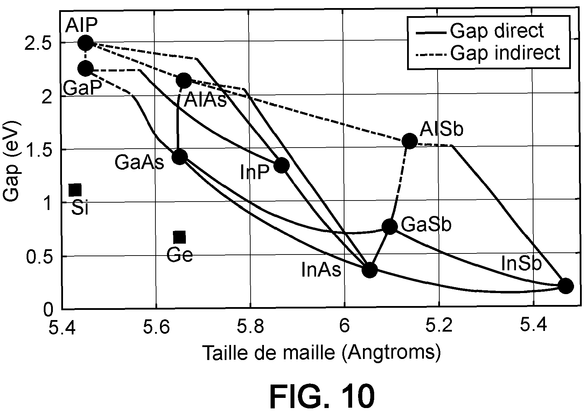

Pour des matériaux III-V comme sous-couches ou substrats, les paramètres de maille, ainsi que leurs gaps, sont fournis en figure 10. En général, il convient en effet d'utiliser le matériau III-V comme couche inférieure, du fait des faibles gaps obtenus sur ces matériaux (en effet, les matériaux de plus hauts gaps sont à gaps indirects, et ne permettent pas d'atteindre une efficacité satisfaisante dans cette application de cellule en tandem). Il est possible d'envisager des matériaux supports tels que GaAs, InP, GaSb et leurs alliages qui permettraient de rester dans des gammes de paramètres de maille et de gaps similaires.

Le tableau ci-après propose des compositions de pérovskites inorganiques à haut gap et donc adaptées pour un tandem pérovskite sur matériau III-V. En outre, parmi ces pérovskites candidates, on a sélectionné celles ayant un nombre de modes de vibration instables inférieur à 10.

| **Pérovskite** | **a (Å)** | **E_{g} (eV)** | **Nᵢₘ** |
|---|---|---|---|
| RbSnCl₃ | 5.602 | 1.896 | 9 |
| RbGe_{0.5}Pb_{0.5}(Cl_{0.25}Br_{0.75})₃ | 5.7 | 1.651 | 9 |
| RbGe_{0.375}Pb_{0.625}(Cl_{0.25}Br_{0.75})₃ | 5.744 | 1.899 | 6 |
| RbGe_{0.5}Pb_{0.5}Br₃ | 5.755 | 1.718 | 6 |
| CsSn_{0.875}Pb_{0.125}Cl₃ | 5.66 | 2.139 | 9 |
| CsSn_{0.75}Pb_{0.25}Cl₃ | 5.673 | 2.279 | 6 |
| CsGe_{0.375}Pb_{0.625}(Cl_{0.75}Br_{0.25})₃ | 5.675 | 2.295 | 6 |
| CsSn(Cl_{0.75}Br_{0.25})₃ | 5.714 | 1.658 | 9 |
| CsSn_{0.875}Pb_{0.125}(Cl_{0.75}Br_{0.25})₃ | 5.726 | 1.723 | 6 |
| CsGe_{0.375}Pb_{0.625}(Cl_{0.5}Br_{0.5})₃ | 5.736 | 2.195 | 6 |
| CsGe_{0.125}Sn_{0.875}(Cl_{0.5}Br_{0.5})₃ | 5.74 | 1.507 | 9 |
| CsSn_{0.75}Pb_{0.25}(Cl_{0.75}Br_{0.25})₃ | 5.742 | 2.043 | 9 |
| CsSn_{0.625}Pb_{0.375}(Cl_{0.75}Br_{0.25})₃ | 5.749 | 1.884 | 0 |
| CsSn_{0.5}Pb_{0.5}(Cl_{0.75}Br_{0.25})₃ | 5.761 | 1.936 | 0 |
| CsSn(Cl_{0.5}Br_{0.5})₃ | 5.777 | 1.597 | 6 |
| CsSn_{0.875}Pb_{0.125}(Cl_{0.5}Br_{0.5})₃ | 5.788 | 1.677 | 6 |
| CsSn_{0.25}Pb_{0.75}(Cl_{0.75}Br_{0.25})₃ | 5.788 | 2.299 | 6 |
| CsGe_{0.375}Pb_{0.625}(Cl_{0.25}Br_{0.75})₃ | 5.791 | 2.008 | 9 |
| CsGe_{0.375}Pb_{0.625}(Cl_{0.75}I_{0.25})₃ | 5.797 | 1.616 | 9 |
| CsSn_{0.75}Pb_{0.25}(Cl_{0.5}Br_{0.5})₃ | 5.799 | 1.763 | 6 |
| CsSn_{0.625}Pb_{0.375}(Cl_{0.5}Br_{0.5})₃ | 5.814 | 1.931 | 9 |
| CsSn_{0.5}Pb_{0.5}(Cl_{0.5}Br_{0.5})₃ | 5.829 | 2.162 | 9 |
| CsGe_{0.25}Pb_{0.75}(Cl_{0.75}I_{0.25})₃ | 5.837 | 1.631 | 6 |
| CsSn_{0.375}Pb_{0.625}(Cl_{0.5}Br_{0.5})₃ | 5.84 | 2.236 | 6 |
| CsSn_{0.25}Pb_{0.75}(Cl_{0.5}Br_{0.5})₃ | 5.851 | 2.295 | 6 |
| CsGe_{0.25}Pb_{0.75}(Cl_{0.25}Br_{0.75})₃ | 5.857 | 2.245 | 9 |
| CsSn_{0.75}Pb_{0.25}(Cl_{0.25}Br_{0.75})₃ | 5.859 | 1.655 | 6 |
| CsSn_{0.625}Pb_{0.375}(Cl_{0.25}Br_{0.75})₃ | 5.873 | 1.727 | 6 |
| CsGe_{0.125}Pb_{0.875}(Cl_{0.75}I_{0.25})₃ | 5.873 | 1.756 | 3 |
| CsSn_{0.5}Pb_{0.5}(Cl_{0.25}Br_{0.75})₃ | 5.883 | 1.775 | 3 |
| CsSn_{0.375}Pb_{0.625}(Cl_{0.25}Br_{0.75})₃ | 5.897 | 2.016 | 3 |
| CsSn_{0.375}Pb_{0.625}(Cl_{0.75}I_{0.25})₃ | 5.904 | 1.679 | 9 |
| CsGe_{0.25}Pb_{0.75}Br₃ | 5.906 | 2.186 | 6 |
| CsSn_{0.25}Pb_{0.75}(Cl_{0.25}Br_{0.75})₃ | 5.916 | 2.225 | 6 |
| CsSn_{0.75}Pb_{0.25}Br₃ | 5.916 | 1.618 | 6 |
| CsSn_{0.125}Pb_{0.875}(Cl_{0.75}I_{0.25})₃ | 5.924 | 1.512 | 9 |
| CsSn_{0.625}Pb_{0.375}Br₃ | 5.93 | 1.755 | 3 |
| CsSn_{0.5}Pb_{0.5}Br₃ | 5.943 | 1.925 | 0 |
| CsSn_{0.375}Pb_{0.625}Br₃ | 5.956 | 2.045 | 3 |
| CsGe_{0.375}Pb_{0.625}(Br_{0.75}I_{0.25})₃ | 5.959 | 1.671 | 6 |
| CsSn_{0.25}Pb_{0.75}Br₃ | 5.97 | 2.19 | 6 |
| CsGe_{0.25}Pb_{0.75}(Cl_{0.5}I_{0.5})₃ | 5.993 | 1.84 | 9 |
| CsGe_{0.25}Pb_{0.75}(Br_{0.75}I_{0.25})₃ | 6.003 | 1.744 | 6 |
| CsGe_{0.5}Pb_{0.5}(Br_{0.5}I_{0.5})₃ | 6.013 | 1.578 | 6 |
| CsGe_{0.125}Pb_{0.875}(Br_{0.75}I_{0.25})₃ | 6.044 | 1.891 | 6 |
| CsGe_{0.375}Pb_{0.625}(Br_{0.5}I_{0.5})₃ | 6.055 | 1.679 | 6 |
| CsSn_{0.375}Pb_{0.625}(Br_{0.75}I_{0.25})₃ | 6.063 | 1.675 | 9 |
| CsGe_{0.375}Pb_{0.625}(Cl_{0.25}I_{0.75})₃ | 6.089 | 1.51 | 6 |
| CsGe_{0.25}Pb_{0.75}(Br_{0.5}I_{0.5})₃ | 6.094 | 1.812 | 3 |

A nouveau, on peut retenir typiquement du tableau ci-dessus des pérovskites qui sont :
- stables (et notamment disposant d'un nombre réduit de modes de vibration instables, selon une étude phononique du type présenté ci-avant),
- adaptées en gap pour des applications tandem,
- avec un accord de maille parfait en pratique (écart maximal de 1%), sans aucun besoin de couche tampon, ni aucun risque de dislocation,
pour un dépôt sur un matériau III-V usuel qui est GaAs, avec les pérovskites de compositions respectives :
RbSnCl₃, RbGe_{0.5}Pb_{0.5}(Cl_{0.25}Br_{0.75})₃, CsSn_{0.875}Pb_{0.125}Cl₃, CsSn_{0.75}Pb_{0.25}Cl₃, CsGe_{0.375}Pb_{0.625}(Cl_{0.75}Br_{0.25})₃ On peut choisir ensuite, parmi ces candidats, les pérovskites les moins polluantes (par exemple en éliminant celles au plomb), ou encore les moins onéreuses, ou autres choix.

Pour un dépôt sur un matériau III-V usuel tel que InP, on peut sélectionner les pérovskites de compositions respectant l'accord de maille :
CsSn_{0.625}Pb_{0.375}(Cl_{0.5}Br_{0.5})₃, CsSn_{0.5}Pb_{0.5}(Cl_{0.5}Br_{0.5})₃, CsGe_{0.25}Pb_{0.75}(Cl_{0.75}I_{0.25})₃, CsSn_{0.375}Pb_{0.625}(Cl_{0.5}Br_{0.5})₃, CsSn_{0.25}Pb_{0.75}(Cl_{0.5}Br_{0.5})₃, CsGe_{0.25}Pb_{0.75}(Cl_{0.25}Br_{0.75})₃, CsSn_{0.75}Pb_{0.25}(Cl_{0.25}Br_{0.75})₃, CsSn_{0.625}Pb_{0.375}(Cl_{0.25}Br_{0.75})₃, CsGe_{0.125}Pb_{0.875}(Cl_{0.75}I_{0.25})₃, CsSn_{0.5}Pb_{0.5}(Cl_{0.25}Br_{0.75})₃, CsSn_{0.375}Pb_{0.625}(Cl_{0.25}Br_{0.75})₃, CsSn_{0.375}Pb_{0.625}(Cl_{0.75}I_{0.25})₃, CsGe_{0.25}Pb_{0.75}Br₃, CsSn_{0.25}Pb_{0.75}(Cl_{0.25}Br_{0.75})₃, CsSn_{0.75}Pb_{0.25}Br₃, CsSn_{0.125}Pb_{0.875}(Cl_{0.75}I_{0.25})₃, CsSn_{0.625}Pb_{0.375}Br₃

Et parmi celles-ci, celles à nombre de modes instables encore réduit à 6 modes au maximum : CsGe_{0.25}Pb_{0.75}(Cl_{0.75}I_{0.25})₃, CsSn_{0.375}Pb_{0.625}(Cl_{0.5}Br_{0.5})₃, CsSn_{0.25}Pb_{0.75}(Cl_{0.5}Br_{0.5})₃, CsSn_{0.75}Pb_{0.25}(Cl_{0.25}Br_{0.75})₃, CsSn_{0.625}Pb_{0.375}(Cl_{0.25}Br_{0.75})₃, CsGe_{0.125}Pb_{0.875}(Cl_{0.75}I_{0.25})₃, CsSn_{0.5}Pb_{0.5}(Cl_{0.25}Br_{0.75})₃, CsSn_{0.375}Pb_{0.625}(Cl_{0.25}Br_{0.75})₃, CsGe_{0.25}Pb_{0.75}Br₃, CsSn_{0.25}Pb_{0.75}(Cl_{0.25}Br_{0.75})₃, CsSn_{0.75}Pb_{0.25}Br₃, et CsSn_{0.625}Pb_{0.375}Br₃.

Ainsi pour généraliser ce qui précède, pour un accord de maille avec du CIGS à haut gap, les pérovskites ayant les formules générales suivantes conviennent :
RbGeₓSn₁₋ₓ(Cl_{y}Br_{1-y})₃ : avec x compris entre 0.375 et 0.5 et y compris entre 0.5 et 0.75.

Pour un accord de maille avec du CIGS à bas gap, les pérovskites ayant les formules générales suivantes conviennent :
RbGeₓSn₁₋ₓ(Cl_{y}Br_{1-y})₃ : avec x compris entre 0 et 0.25 et y compris entre 0.75 et 1
RbGeₓPb₁₋ₓ(Cl_{y}Br_{1-y})₃ : avec x compris entre 0.375 et 0.5 et y compris entre 0 et 0.25
CsGeₓSn₁₋ₓ(Cl_{y}Br_{1-y})₃ : avec x compris entre 0 et 0.125 et y compris entre 0.5 et 0.75
CsGeₓPb₁₋ₓ(Cl_{y}Br_{1-y})₃ : avec x égal à 0.375 et y compris entre 0.25 et 0.75
CsSnₓPb₁₋ₓ(Cl_{y}Br_{1-y})₃ : avec x compris entre 0.5 et 1, et y compris entre 0.5 et 1.

Pour un accord de maille maintenant avec un matériau III-V, les pérovskites suivantes peuvent être utilisées :
RbSnCl₃ : avec x compris entre 0.125 et 0.75 et y compris entre 0 et 0.75
RbGeₓPb₁₋ₓ(Cl_{y}Br_{1-y})₃ : avec x compris entre 0.375 et 0.5 et y compris entre 0 et 0.25
CsGeₓSn₁₋ₓ(Cl_{y}Br_{1-y})₃ : avec x compris entre 0 et 0.125, y compris entre 0.5 et 0.75
CsGeₓPb₁₋ₓ(Cl_{y}Br_{1-y})₃ : avec x compris entre 0.25 et 0.375, y compris entre 0 et 0.75
CsGeₓPb₁₋ₓ(Br_{y}I_{1-y})₃ : avec x compris entre 0.25 et 0.5, y compris entre 0.5 et 1
CsGeₓPb₁₋ₓ(Cl_{y}I_{1-y})₃ : avec x compris entre 0.125 et 0.375, y compris entre 0.25 et 0.75
CsSnₓPb₁₋ₓ(Cl_{y}Br_{1-y})₃ : avec x compris entre 0.25 et 1, y compris entre 0.25 et 1
CsSnₓPb₁₋ₓ(Br_{y}I_{1-y})₃ : avec x compris entre 0.25 et 0.75, y égal à 1.

Pour ce qui concerne le gap et en termes de stabilité encore, il convient de rappeler que les pérovskites inorganiques, notamment halogénées, sont sujettes à une riche séquence de transitions de phase. Dans la plupart des cas, ces transitions de phase peuvent se produire dans des gammes de température qui peuvent être atteintes dans un dispositif photovoltaïque (des cellules solaires notamment).

Bien que ces transitions de phase ne mènent pas toujours à une phase non-photoactive, elles viennent directement altérer les propriétés du matériau.

D'une part, l'apparition de distorsions au sein du réseau d'octahèdres BX₆ vient causer la modification des paramètres de maille, ce qui peut générer de la tension au sein du matériau. D'autre part, ces distorsions vont causer aussi une modification de l'interaction entre les orbitales des atomes B et X, qui importent beaucoup dans les états électroniques proches de la bande interdite.

La figure 11a présente le diagramme d'orbitale simplifié à proximité de la bande interdite : à cet endroit, les états de la bande de valence et de la bande de conduction sont le résultat de la combinaison anti-liantes des orbitales des atomes B et X. En changeant la symétrie, ou les distances entre les atomes, on vient modifier l'intensité de l'interaction, ce qui implique des conséquences directes sur les alignements de bande, la largeur de la bande interdite, mais aussi la mobilité des porteurs de charge et donc la performance des cellules.

Il apparaît donc important de considérer aussi la stabilité dynamique des pérovskites, ce qui a été considéré dans le fil de toute la présente description, notamment pour parvenir aux listes de pérovskites données ci-avant, notamment dans les tableaux ci-dessus.

De manière plus générale, la présente description ne se limite pas aux formes de réalisation décrites ci-avant à titre d'exemple, mais elle s'étend à d'autres variantes, notamment relativement aux techniques de fabrication de dispositifs électroniques (notamment photovoltaïques) dits « en couches minces ». Les matériaux d'une au moins de ces couches minces sont choisis dans la famille des pérovskites inorganiques de composition stœchiométrique générale ABX₃ où :
- A est un élément parmi Cs et Rb,
- B est un élément ou un mélange d'éléments parmi Ge, Sn et Pb, et
- X est un élément ou un mélange d'éléments parmi Cl, Br et I,
du moment où leur facteur de tolérance de Goldschmidt t est bien compris entre 0,87 et 0,93.

## Revendications

1. Dispositif électronique comportant au moins une couche réalisée dans un matériau comportant une pérovskite inorganique :
* de composition stœchiométrique ABX₃ où :
- A est un élément parmi Cs et Rb,
- B est un élément ou un mélange d'éléments parmi Ge, Sn et Pb, et
- X est un élément ou un mélange d'éléments parmi Cl, Br et I,
* et ayant un facteur de Goldschmidt t compris entre 0,87 et 0,93.

2. Dispositif selon la revendication 1, dans lequel le matériau est au moins partiellement cristallin selon une structure cristallographique de type *Pm3m.*

3. Dispositif selon l'une des revendications précédentes, dans lequel la pérovskite inorganique est de composition stœchiométrique A(B_{z}B'_{1-z})(X_{y}X'_{1-y})₃ où :
- z et y sont compris entre 0 et 1,
- A est un élément parmi Cs et Rb,
- B et B' sont des éléments distincts parmi Ge, Sn et Pb, et
- X et X' sont des éléments distincts parmi Cl, Br et I.

4. Dispositif selon l'une des revendications précédentes, dans lequel le matériau est dépourvu de mode de vibration instable et est choisi parmi les compositions : CsGe_{0.25}Pb_{0.75}(Br_{0.5}Cl_{0.5})₃, CsPb_{0.125}Sn_{0.875}I₃, CsPb_{0.25}Sn_{0.75}I₃, CsPb_{0.375}Sn_{0.625}(Br_{0.25}Cl_{0.75})₃, CSPb_{0.5}Sn_{0.5}(Br_{0.25}Cl_{0.75})₃, CsPb_{0.5}Sn_{0.5}Br₃, CsPb_{0.5}Sn_{0.5}Cl₃, CsPb_{0.625}Sn_{0.375}Cl₃, et CsPb_{0.75}Sn_{0.25}Cl₃.

5. Dispositif selon l'une des revendications précédentes, le dispositif étant de type photovoltaïque, dans lequel ladite couche est à propriétés photovoltaïques et le matériau :
- est dépourvu de mode de vibration instable,
- a une largeur de bande interdite comprise entre 1,4eV et 2,3eV, et
- est choisi parmi les compositions CsPb_{0.375}Sn_{0.625}(Br_{0.25}Cl_{0.75})₃, CSPb_{0.5}Sn_{0.5}(Br_{0.25}Cl_{0.75})₃, et CsPb_{0.5}Sn_{0.5}Br₃.

6. Dispositif selon l'une des revendications précédentes, de type photovoltaïque et comportant une première couche d'un premier matériau et une deuxième couche d'un deuxième matériau, le deuxième matériau comportant une pérovskite inorganique à propriétés photovoltaïques ayant un facteur de Goldschmidt t compris entre 0,87 et 0,93, une largeur de bande interdite choisie, et une composition choisie pour un accord de maille avec le premier matériau, la première et la deuxième couchée étant déposées l'une sur l'autre,
le deuxième matériau ayant un nombre de modes de vibration instables, inférieur à un seuil.

7. Dispositif selon la revendication 6, le dispositif étant de type à cellule tandem ou multi-jonctions, le premier matériau étant du silicium et ladite deuxième couche comporte une pérovskite inorganique à propriétés photovoltaïques avec une largeur de bande interdite comprise entre 1,4eV et 2,3eV,
la pérovskite inorganique ayant une composition de type Rb(PbₓSn₁₋ₓ)Br₃, avec x compris entre 0 et 0,7, avec une taille de maille proche d'une taille de maille du silicium, de sorte que les couches de silicium et de pérovskite sont déposées l'une sur l'autre.

8. Dispositif selon la revendication 6, le dispositif étant de type à cellule tandem ou multi-jonctions, le premier matériau étant du CuGaSe₂ et ladite deuxième couche comporte une pérovskite inorganique à propriétés photovoltaïques avec une largeur de bande interdite comprise entre 0,4eV et 1,3eV, et une composition parmi RbGe_{0.5}Sn_{0.5}(Cl_{0.75}I_{0.25})₃, RbGe_{0.625}Pb_{0.375}(Cl_{0.75}I_{0.25})₃ et RbGe_{0.5}Sn_{0.5}(Cl_{0.25}Br_{0.75})₃.

9. Dispositif selon la revendication 6, le dispositif étant de type à cellule tandem ou multi-jonctions, le premier matériau étant du CuInSe₂ et ladite deuxième couche comporte une pérovskite inorganique à propriétés photovoltaïques avec une largeur de bande interdite comprise entre 1,5eV et 2,3eV, et une composition parmi :
RbGe_{0.375}Pb_{0.625}(Cl_{0.25}Br_{0.75})₃, RbGe_{0.5}Pb_{0.5}Br₃, CsSn_{0.375}Pb_{0.125}(Cl_{0.75}Br_{0.25})₃, CsGe_{0.375}Pb_{0.625}(Cl_{0.5}Br_{0.5})₃, CsGe_{0.125}Sn_{0.875}(Cl_{0.5}Br_{0.5})₃, CsSn_{0.75}Pb_{0.25}(Cl_{0.75}Br_{0.25})₃, CsSn_{0.625}Pb_{0.375}(Cl_{0.75}Br_{0.25})₃, CsSn_{0.5}Pb_{0.5}(Cl_{0.75}Br_{0.25})₃, CsSn(Cl_{0.5}Br_{0.5})₃, CsSn_{0.875}Pb_{0.125}(Cl_{0.5}Br_{0.5})₃, CsSn_{0.25}Pb_{0.75}(Cl_{0.75}Br_{0.25})₃, CsGe_{0.375}Pb_{0.625}(Cl_{0.25}Br_{0.75})₃, CsGe_{0.375}Pb_{0.625}(Cl_{0.75}I_{0.25})₃, CsSn_{0.75}Pb_{0.25}(Cl_{0.5}Br_{0.5})₃.

10. Dispositif selon la revendication 6, le dispositif étant de type à cellule tandem ou multi-jonctions, le premier matériau étant du GaAs et ladite deuxième couche comporte une pérovskite inorganique à propriétés photovoltaïques avec une largeur de bande interdite comprise entre 1,5eV et 2,1eV, et une composition parmi :
RbSnCl₃, RbGe_{0.5}Pb_{0.5}(Cl_{0.25}Br_{0.75})₃, CsSn_{0.375}Pb_{0.125}Cl₅, CsSn_{0.75}Pb_{0.25}Cl₃, CsGe_{0.375}Pb_{0.625}(Cl_{0.75}Br_{0.25})₃.

11. Dispositif selon la revendication 6, le dispositif étant de type à cellule tandem ou multi-jonctions, le premier matériau étant du InP et ladite deuxième couche comporte une pérovskite inorganique à propriétés photovoltaïques avec une largeur de bande interdite comprise entre 1,5eV et 2,3eV, et une composition parmi :
CsSn_{0.625}Pb_{0.375}(Cl_{0.5}Br_{0.5})₃, CsSn_{0.5}Pb_{0.5}(Cl_{0.5}Br_{0.5})₃, CsGe_{0.25}Pb_{0.75}(Cl_{0.75}I_{0.25})₃, CsSn_{0.375}Pb_{0.625}(Cl_{0.5}Br_{0.5})₃, CsSn_{0.25}Pb_{0.75}(Cl_{0.5}Br_{0.5})₃, CsGe_{0.25}Pb_{0.75}(Cl_{0.25}Br_{0.75})₃, CsSn_{0.75}Pb_{0.25}(Cl_{0.25}Br_{0.75})₃, CsSn_{0.625}Pb_{0.375}(Cl_{0.25}Br_{0.75})₃, CsGe_{0.125}Pb_{0.875}(Cl_{0.75}I_{0.25})₃, CsSn_{0.5}Pb_{0.5}(Cl_{0.25}Br_{0.75})₃, CsSn_{0.375}Pb_{0.625}(Cl_{0.25}Br_{0.75})₃, CsSn_{0.375}Pb_{0.625}(Cl_{0.75}I_{0.25})₃, CsGe_{0.25}Pb_{0.75}Br₃, CsSn_{0.25}Pb_{0.75}(Cl_{0.25}Br_{0.75})₃, CsSn_{0.75}Pb_{0.25}Br₃, CsSn_{0.125}Pb_{0.875}(Cl_{0.75}I_{0.25})₃, CsSn_{0.625}Pb_{0.375}Br₃.

12. Dispositif selon l'une des revendications précédentes, le dispositif étant de type supercondensateur, dans lequel le matériau est dépourvu de mode de vibration instable et est choisi, pour des effets super-capacitifs, parmi les compositions : CsGe_{0.25}Pb_{0.75}(Br_{0.5}Cl_{0.5})₃, CsPb_{0.125}Sn_{0.875}I₃, CsPb_{0.25}Sn_{0.75}I₃, et CsPb_{0.5}Sn_{0.5}(Br_{0.25}Cl_{0.75})₃.
